**Europäisches Patentamt**

(19) **European Patent Office**

**Office européen des brevets**

(11) Numéro de publication: **0 056 568 B1**

## FASCICULE DE BREVET EUROPEEN

(12)

(45) Date de publication du fascicule du brevet:
30.05.84

(51) Int. Cl.³: **H 03 B 5/12**, G 08 B 21/00, G 01 P 3/42

(21) Numéro de dépôt: 81870006.4

(22) Date de dépôt: 21.01.81

(54) **Oscillateur à seuil de sécurité.**

(43) Date de publication de la demande:
28.07.82 Bulletin 82/30

(45) Mention de la délivrance du brevet:
30.05.84 Bulletin 84/22

(84) Etats contractants désignés:
**AT BE CH DE FR GB IT LI LU NL SE**

(56) Documents cités:
**DE - A - 2 105 045
DE - B - 1 171 030
DE - B - 1 210 921
DE - B - 2 403 402
DE - B - 2 526 346
GB - A - 1 340 902
US - A - 2 954 527
US - A - 3 286 199
US - A - 3 503 007
US - A - 3 636 470
US - A - 3 737 806**

(73) Titulaire: **ATELIERS DE CONSTRUCTIONS ELECTRIQUES DE CHARLEROI (ACEC) Société Anonyme, Avenue Lloyd George 7, B-1050 Bruxelles (BE)**

(72) Inventeur: **Dutilloeil, Jacques, Allée des Trois Tilleuls, 10, B-1400 Nivelles (BE)**

(74) Mandataire: **Bossard, Franz, ACEC - Service des Brevets Boîte Postale 4, B-6000 Charleroi (BE)**

ACTORUM AG

## Description

La présente invention se rapporte à un oscillateur de sécurité qui ne démarre que lorsque les composants du dispositif sont sains et que le ou les signaux d'entrée sont supérieurs à un seuil de tension prédéterminé, sont égaux entre eux, ou sont dans un rapport connu.

Son avantage principal consiste en ce qu'en cas d'avarie des composants, cet oscillateur ne démarre pas, quelle que soit la tension de commande. De plus il est réalisé à l'aide de composants discrets faciles à contrôler pour garantir une sécurité supérieure à celle obtenue pour l'utilisation de micro-circuits pour lesquels un défaut interne à la structure n'est pas prévisible. Enfin par le choix même des composants tels que condensateurs à quatre bornes et résistances à couche, la probabilité de pannes du dispositif se situe au niveau le plus bas.

Toute coupure ou tout court-circuit accidentel survenant à un composant tel que condensateur, transistor, diode Zéner, enroulement de transformateur ou résistance, empêche cet oscillateur à seuil de sécurité de démarrer. Il en est de même si une réduction différentielle de tension, supérieure à un écart correspondant à un dépassement de tolérances, apparaît aux bornes des diodes Zéner ou d'autre élément formant la paire de comparaison.

Dans un premier exemple de réalisation l'oscillateur à seuil de sécurité possède deux branches, constituée chacune d'un transistor, d'une résistance et d'une diode de Zéner, qui font office de «fléau de balance». Lorsqu'une branche est en déséquilibre par rapport à l'autre branche, le transistor de cette autre branche reste bloqué quel que soit le niveau de tension émis par le générateur branché ses bornes d'entrée et de la sorte l'oscillateur ne peut démarrer. L'invention sera exposée plus en détails à l'aide des figures suivantes.

La figure 1 représente un schéma, donné à titre d'exemple, d'un oscillateur qui entre en fonctionnement dès que le signal d'entrée atteint une référence donnée.

La figure 2 représente un schéma donné à titre d'exemple, d'un oscillateur qui entre en fonctionnement dès que les signaux d'entrée sont identiques.

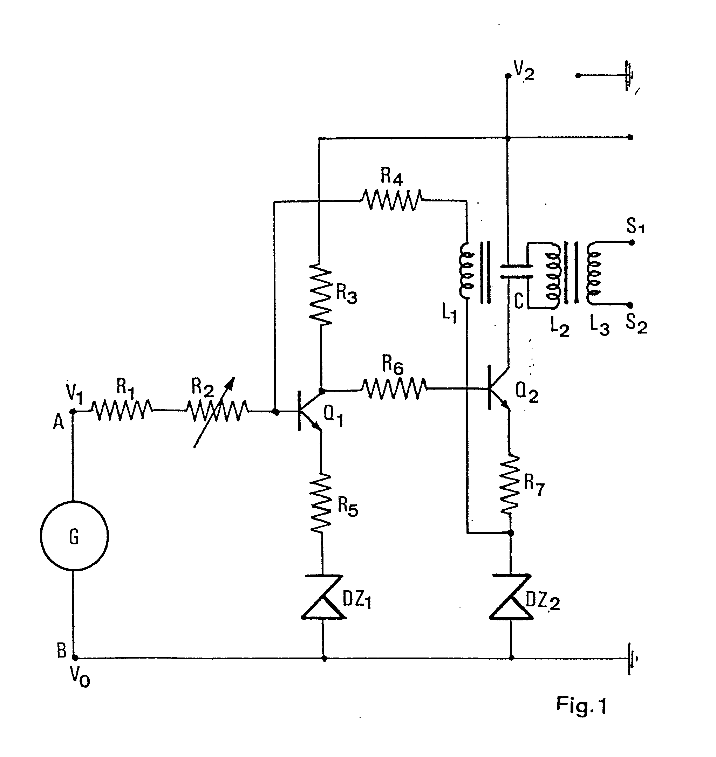

L'oscillateur à seuil de sécurité, donné à titre d'exemple dans la figure 1, est composé de deux transistors $Q_1$ et $Q_2$ du type NPN montés en émetteur commun, de deux diodes de Zéner $DZ_1$ et $DZ_2$ à caractéristiques aussi identiques que possible, d'un transformateur TF à trois enroulements $L_1$, $L_2$ et $L_3$ associé à une capacité C à quatre bornes pour former un circuit oscillant, et de plusieurs résistances judicieusement calibrées. Chaque transistor $Q_1$ ou $Q_2$ a son émetteur relié à une diode de Zéner $DZ_1$ ou $DZ_2$ par l'intermédiaire d'une résistance de stabilisation $R_5$ ou $R_7$. La base du transistor $Q_1$ est reliée à une borne d'entrée A de l'oscillateur par l'intermédiaire d'une résistance fixe $R_1$ et d'une résistance réglable $R_2$. Le collecteur du transistor $Q_1$ est relié d'une part à la tension d'alimentation continue $V_2$ par l'intermédiaire d'une résistance $R_3$ et d'autre part à la base du transistor $Q_2$ par l'intermédiaire de la résistance $R_6$. Le collecteur du transistor $Q_2$ est relié à la tension d'alimentation continue $V_2$ par l'intermédiaire de certains éléments ($L_2$, C) du circuit oscillant ($L_1$, $L_2$, $L_3$, C, $R_4$). Une boucle de réaction positive réunit l'émetteur du transistor $Q_2$ à la base du transistor $Q_1$ par l'intermédiaire des résistances $R_7$ et $R_4$ et de l'enroulement $L_1$ du transformateur TF.

Cet oscillateur est alimenté en tension continue $V_2$ et un générateur de tension G est branché entre les bornes d'entrée A et B de l'oscillateur pour lui fournir un signal à une tension $V_1$ supérieure à un seuil imposé par la tension des diodes de Zéner $DZ_1$ et $DZ_2$ augmentée de la chute de tension entre la base et l'émetteur $V_{BE}$ des transistors $Q_1$ et $Q_2$ et la chute ohmique des résistances de stabilisation $R_5$ et $R_7$. Ce seuil de tension est réglable à une valeur prédéterminée par la résistance variable $R_2$.

En fonctionnement normal c'est-à-dire lorsque tous les composants sont sains, l'oscillateur se comporte de la manière suivante.

Aussi longtemps que la tension engendrée par le générateur G reste inférieure au seuil prédéterminé par la tension des diodes de Zéner $DZ_1$ et $DZ_2$, la chute de tension entre la base et l'émetteur des transistors $Q_1$ et $Q_2$ et la chute ohmique dans les résistances $R_1$ et $R_2$, l'oscillateur ne démarre pas et ne délivre aucun signal de sortie à ses bornes $S_1$ et $S_2$. Dès que la tension aux bornes d'entrée A et B de l'oscillateur dépasse le seuil prédéterminé, les diodes de Zéner $DZ_1$ et $DZ_2$ sont conductrices et le transistor $Q_1$ présentant une distribution de potentiel à ses bornes telle que le potentiel du collecteur soit supérieur au potentiel de la base, $V_{CB} > 0$, et que le potentiel de la base soit supérieur au potentiel de l'émetteur, $V_{BE} > 0$, devient conducteur. Le seuil de tension est alors perçu par la base du transistor $Q_2$ qui a son tour, ayant une distribution de potentiel convenable à ses bornes, devient conducteur. La variation de tension transmise par le transistor $Q_2$ engendre une force électromotrice dans le circuit oscillant qui se met à osciller à sa fréquence propre.

Les oscillations sont ensuite entretenues par la boucle de réaction positive connectée à la base du transistor $Q_1$.

Le comportement du dispositif en cas d'avarie sera considéré à travers différentes pannes analysées successivement.

Supposons dans un premier cas que l'une des diodes de Zéner présente un seuil de tension très inférieur à l'écart toléré.

Soit dans un premier exemple le diode de Zéner $DZ_2$ ayant un seuil de tension nettement inférieur à celui de la diode de Zéner $DZ_1$.

Dès que le générateur G émet une tension supérieure au seuil de sécurité prédéterminé, la branche, formée de la diode de Zéner $DZ_1$, de la résistance $R_5$ et du transistor $Q_1$, étant composée d'éléments sains impose à l'émetteur du transis-

tor $Q_1$ le même potential qu'en fonctionnement normal. Toutefois à cause de la trop faible tension de a diode de Zéner $DZ_2$ la base du transistor $Q_1$, via la résistance $R_4$ est elle aussi à un potentiel imposé trop faible. En conséquence la condition $V_{BE} > O$ ne se réalise pas, le transistor $Q_1$ ne conduit pas et ne peut transmettre vers la base du transistor $Q_2$ le seuil de tension généré aux bornes de l'oscillateur.

Dans un seconde cas, considérons la diode de Zéner $DZ_1$ défectueuse et affichant une tension de seuil nettement inférieure à celle de la diode de Zéner $DZ_2$ en bon état de fonctionnement. La faible tension de seuil de la diode Zéner $DZ_1$ réduit le potentiel de l'émetteur du transistor $Q_1$ mais ne contrarie pas la distribution de potentiel aux bornes du transistor $Q_1$ qui est conducteur puisque $V_{CB} > O$ et $V_{BE} > O$. Toutefois dès que le transistor $Q_1$ devient conducteur, il est saturé à cause d'un grand écart de tension entre le potentiel de la base et le potentiel de l'émetteur. Le courant intense qui circule dans le transistor $Q_1$ nivèle les potentiels et diminue le potentiel du collecteur du transistor $Q_1$ par rapport à celui trouvé en conditions normales de fonctionnement. De ce fait, la tension appliquée à la base du transistor $Q_2$ est elle aussi inférieure au potentiel normalement affiché et la condition $V_{BE} > O$ n'est pas réalisée pour le transistor $Q_2$. En conséquence le transistor $Q_2$ ne conduit pas et l'oscillateur ne peut démarrer.

Dans le cas, peu probable, d'une court-circuit simultané sur les deux diodes de Zéner $DZ_1$ et $DZ_2$ on peut installer un système redondant constitué de plusieurs diodes de Zéner mises en série dans chaque branche et répondant à la condition

$$\sum_{i=1}^{i=n} DZ_1^i \;=\; \sum_{i=1}^{i=n} DZ_2^i$$

Pour répondre à certaines applications particulières, des compensations thermiques peuvent être introduites au moyen de résistances à coefficient thermique negatif montées en série avec ces résistances ohmiques du schéma de la figure 1. Par exemple, en plaçant une résistance à coefficient thermique négatif en série avec la résistance ohmique $R_4$ on stabilise le taux de réaction dans une large gamme de températures.

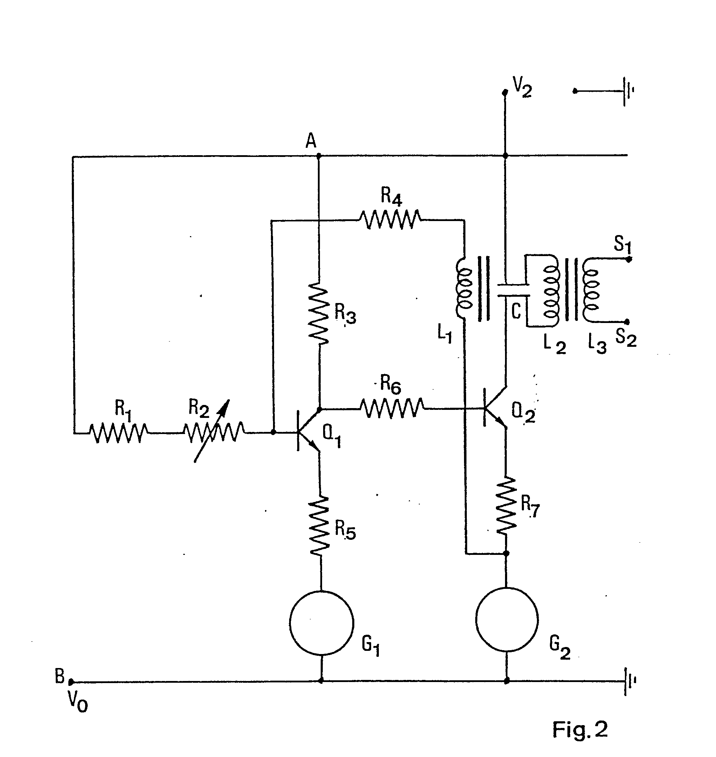

Le même oscillateur de sécurité peut servir de comparateur pour des signaux émis par des éléments formant une paire de comparaison. Il suffit pour cela de remplacer les deux diodes de Zéner de la figure 1 par d'autres éléments dont les caractéristiques de fonctionnement sont aussi proches que possible. La figure 2 montre un exemple dans laquelle la paire de comparaison a été constituée de deux générateurs $G_1$ et $G_2$ de même impédance.

Dans cette même figure, le point A est connecté à la source $V_2$ et garde une valeur fixe. Dans ce schéma, lorsque ces tensions émises respectivement par $G_1$ et $G_2$ sont égales et atteignent un seuil prédéterminé, l'oscillateur fonctionne et concrétise par un signal de sécurité l'état de bon fonctionnement des dispositifs à surveiller. Par exemple, les générateurs $G_1$ et $G_2$ peuvent être dans dynamos tachymétriques indiquant la vitesse de rotation des différentes machines devant fonctionner à des vitesses sensiblement égales.

Dans un autre montage, non représenté, le point A reste branché à la borne du générateur G. De cette façon on peut établir une série d'égalités entre $G_1$ et $G_2$ chaque fois que $G_1$, $G_2$ et G ont des tensions égales.

Un oscillateur réalisé selon l'invention et associé à un amplificateur constitue un ensemble de haute sécurité qui ne délivre de signal que si toute une série de conditions sont simultanément réalisées; à savoir: alimentation en tensions $V_1$ et $V_2$ convenables et bon état de fonctionnement des composants.

Cet ensemble oscillateur-amplificateur connecté par exemple à un relais de gravitation marque lorsque celui-ci est excité l'état de bon fonctionnement ou dans le cas contraire il indique la défaillance et déclenche éventuellement les mesures qui s'imposent pour y remédier.

Bien entendu, l'invention ne se limite pas à la réalisation de l'oscillateur à seuil de sécurité donné à titre d'exemple. Elle comprend par exemple celui d'un oscillateur réalisé avec des transistors du type PNP.

**Revendications**

1. Oscillateur comportant un élément semiconducteur $(Q_2)$ à au moins trois électrodes dont l'électrode de commande est reliée, indirectement via des éléments de réglage de tension ou de courant $(R_1, R_2)$ à une borne d'entrée $(V_1)$, dont une des autres électrodes est reliée à un premier potentiel de référence $(V_o)$ via une résistance $(R_7)$ et un générateur de tension continue ou alternative, plus particulièrement une diode de Zéner $(DZ_2)$, dont une troisième électrode est reliée à un deuxième potentiel de référence $(V_2)$, au travers de certains éléments $(L_2, C)$ d'un circuit oscillant $(L_1, L_2, L_3, C, R_4)$ raccordé à deux bornes de sortie $(S_1$ et $S_2)$, et dont l'électrode de commande est reliée indirectement à la jonction résistance $(R_7)$-générateur de tension $(DZ_2)$, via une boucle de réaction $(L_1, R_4)$ constituée d'autres éléments du circuit oscillant $(L_1, L_2, L_3, C, R_4)$, caractérisé en ce que sur la première branche constituée du générateur de tension $(DZ_2)$ de la résistance $(R_7)$ et de l'élément semiconducteur $(Q_2)$ est montée, en parallèle, une seconde branche comprenant un autre générateur de tension continue ou alternative à caractéristiques sensiblement identiques au générateur monté dans la première branche, plus particulièrement une diode de Zéner $(DZ_1)$, une résistance $(R_5)$ et un élément semi-conducteur $(Q_1)$, en ce qu'une électrode de l'élément semi-conducteur $(Q_1)$ est reliée d'une part à l'électrode de commande de l'élément semi-conducteur $(Q_2)$ par l'intermédiaire d'une résis-

tance (R$_6$) et d'autre part au premier potentiel de référence (V$_2$) par l'intermédiaire d'une résistance (R$_3$) et en ce que l'électrode de commande de l'élément semi-conducteur (Q$_1$) est reliée d'une part à la borne d'entrée (V$_1$), via des éléments de réglage de tension ou de courant (R$_1$, R$_2$) et d'autre part à la jonction résistance (R$_7$)-générateur de tension (DZ$_2$), via la boucle de réaction (L$_1$, L$_4$).

2. Oscillateur selon la revendication 1, caractérisé en ce que la borne d'entrée (V$_1$) est reliée directement au premier potentiel de référence (V$_2$).

3. Oscillateur selon la revendication 1, caractérisé en ce que dans chacune des deux branches montées en parallèle est disposée une diode de Zéner (DZ$_1$ ou DZ$_2$) et en ce que les deux diodes de Zéner (DZ$_1$, DZ$_2$) ont des caractéristiques aussi identiques que possible.

4. Oscillateur selon la revendication 1 ou 3, caractérisé en ce que dans chacune des deux branches montées en parallèles sont disposées plusieurs diodes de Zéner (DZ$_1$, DZ$_2$) et en ce que les valeurs cumulées de caractéristiques des diodes de Zéner de chaque branche sont aussi identiques que possible.

**Claims**

1. Oscillator comprising semiconductor element (Q$_2$) having at least three electrodes of which the control electrode is connected indirectly via current or voltage regulating elements (R$_1$, R$_2$) to an input terminal (V$_1$), of which one of the other electrodes is connected to a first reference potential (V$_0$) via a resistor (R$_7$) and an A.C. or D.C. voltage generator more particularly a Zener diode (DZ$_2$), a third electrode of which is connected to a second reference potential (V$_2$) throug some elements (L$_2$, C) of an oscillatory circuit (L$_1$, L$_2$. L$_3$, C, R$_4$) connected to two output terminals (S$_1$ and S$_2$), and of which the control electrode is connected indirectly to the resistor (R$_7$)-voltage generator (DZ$_2$) junction via a feedback loop (L$_1$, L$_4$) constituted by other elements of the oscillatory circuit (I$_1$, L$_2$, L$_3$, C, R$_4$), characterised in that there is connected up to the first branch constituted by the voltage generator (DZ$_2$) the resistor (R$_7$) and the semiconductor element (Q$_2$), in parallel, a second branch comprising another A.C. or D.C. voltage generator with characteristics substantially identical to the generator arranged in the first branch, more particularly a Zener diode (DZ$_1$), a resistor (R$_5$) and a semiconductor element (Q$_1$), in that one electrode of the semiconductor element (Q$_1$) is connected on the one hand to the control electrode of the semiconductor element (Q$_2$) by way of a resistor (R$_6$) and on the other hand to the first reference potential (V$_2$) by way of a resistor (R$_3$), and in that the control electrode of the semiconductor element (Q$_1$) is connected on the one hand to the input terminal (V$_1$) via current or voltage regulating elements (R$_1$, R$_2$), and on the other hand to the resistor (R$_7$)-voltage generator (DZ$_2$) junction via the feedback loop (L$_1$, L$_4$).

2. Oscillator according to claim 1, characterised in that the input terminal (V$_1$) is connected directly to the first reference potential (V$_2$).

3. Oscillator according to claim 1, characterised in that in each of the two branches, which are connected in parallel, there is arranged a Zener diode (DZ$_1$ or DZ$_2$) and in that the two Zener diodes (DZ$_1$, DZ$_2$) have characteristics as identical as possible.

4. Oscillator according to claim 1 or 3, characterised in that in each of the two branches, which are connected in parallel, there are arranged a plurality of Zener diodes (DZ$_1$, DZ$_2$) and in that the cumulative characteristic values of the Zener diodes of each branch are as identical as possible.

**Patentansprüche**

1. Oscillator, umfassend ein Halbleiterelement (Q$_2$) mit mindestens drei Elektroden, von denen die Steuerelektrode über Spannungs- oder Stromeinstellelemente (R$_1$, R$_2$) indirekt mit einer Eingangsklemme (V$_1$) verbunden ist, von denen eine der anderen Elektroden über einen Widerstand (R$_7$) und einen Gleichspannungs- oder Wechselspannungsgenerator, insbesondere eine Zenerdiode (DZ$_2$) mit einem ersten Bezugspotential (V$_0$) verbunden ist, von denen eine dritte Elektrode über gewisse Elemente (L$_2$, C) eines Schwingkreises (L$_1$, L$_2$, L$_3$, C, R$_4$), der an zwei Ausgangsklemmen (S$_1$ und S$_2$) angeschlossen ist, mit einem zweiten Bezugspotential (V$_2$) verbunden ist, und von denen die Steuerelektrode über eine Rückkopplungsschleife (L$_1$, R$_4$), die aus weiteren Elementen des Schwingkreises (L$_1$, L$_2$, L$_3$, C, R$_4$) besteht, indirekt mit dem Verbindungspunkt zwischen Widerstand (R$_7$) und Spannungsgenerator (DZ$_2$) verbunden ist, dadurch gekennzeichnet, dass parallel zu dem aus dem Spannungsgenerator (DZ$_2$), dem Widerstand (R$_7$) und dem Halbleiterelement (Q$_2$) bestehenden ersten Zweig ein zweiter Zweig geschaltet ist, der einen weiteren Gleichspannungs- oder Wechselspannungsgenerator mit ungefähr gleichen Merkmalen wie der in dem ersten Kreis liegende Generator, insbesondere eine Zenerdiode (DZ$_1$), einen Widerstand (R$_5$) und ein Halbleiterelement (Q$_1$) umfasst; dass eine Elektrode des Halbleiterelements (Q$_1$) einerseits über einen Widerstand (R$_6$) mit der Steuerelektrode des Halbleiterelementes (Q$_2$), und andererseits über einen Widerstand (R$_3$) mit dem ersten Bezugspotential (V$_2$) verbunden ist; und dass die Steuerelektrode des Halbleiterelements (Q$_1$) einerseits über Spannungs- und Stromeinstellelemente (R$_1$, R$_2$) mit der Eingangsklemme (V$_1$), und andererseits über die Rückkopplungsschleife (L$_1$, R$_4$) mit dem Verbindungspunkt zwischen Widerstand (R$_7$) und Spannungsgenerator (DZ$_2$) verbunden ist.

2. Oscillator gemäss Patentanspruch 1 dadurch gekennzeichnet, dass die Eingangsklemme (V$_1$) direkt mit dem ersten Bezugspotential (V$_2$) verbunden ist.

3. Oscillator gemäss Patentanspruch 1, dadurch gekennzeichnet, dass in jedem der zwei parallel geschalteten Zweige eine Zenerdiode (DZ$_1$ oder DZ$_2$) angeordnet ist, und dass die zwei Zenerdioden (DZ$_1$, DZ$_2$) möglichst gleiche Kennlinien haben.

4. Oscillator gemäss Patentanspruch 1 oder 3, dadurch gekennzeichnet, dass in jedem der zwei parallel geschalteten Zweige mehrere Zenerdioden (DZ$_1$, DZ$_2$) angeordnet sind, und dass die kumulierten Werte der Kennlinien der Zenerdioden jedes Zweiges so gleich wie möglich sind.

Fig. 1

Fig. 2